# EUROPEAN PATENT APPLICATION

(11) **EP 1 742 520 A1**
(43) Date of publication of application: **10.01.2007**
(21) Application number: 06013619.9
(22) Date of filing: 30.06.2006
(51) Int. Cl.: H05K 1/02, H05K 9/00

(54) **Wiring board, electronic device, and power supply unit**

(30) Priority: 04.07.2005 JP 2005195294; 02.06.2006 JP 2006154339
(71) Applicant: OMRON CORPORATION, Kyoto-shi, Kyoto 600-8530 (JP)
(72) Inventor: Yamamoto, Shingo c/o Omron Corporation, Shimogyo-ku Kyoto-shi Kyoto 600-8530 (JP); Ishibashi, Hiroyuki c/o Omron Corporation, Shimogyo-ku Kyoto-shi Kyoto 600-8530 (JP); Matsuda, Katsumi c/o Omron Corporation, Shimogyo-ku Kyoto-shi Kyoto 600-8530 (JP)
(74) Representative: Kilian, Helmut

(57) **Abstract**

A wiring board (lead frame) 10 has a configuration in which a high-frequency current suppression member 18 formed of a conductive soft magnetic film 18a having high magnetic permeability is provided in a near field (magnetic field dominant area) in a lead frame part (wiring part) 10a which can be a radiation noise source, preferably, in the periphery of the lead frame part 10a.

## Description

### BACKGROUND OF THE INVENTION

### 1. Field of the Invention

The present invention relates to a wiring board, an electronic device, and a power supply unit such as a switching power supply and relates to a technique of suppressing radiation noise generated from a wiring line.

An electronic device includes all of electronic devices generating high-frequency radiation noise.

The power supply unit is typified by a switching power supply and includes other power supply units each having a power converter such as an AC/DC converter, a DC/DC converter, an inverter, or an uninterruptible power supply.

### 2. Description of the related art

In an electronic device performing high-frequency operation, as the processing speed thereof increases, radiation noise increases, and development of the technique capable of more effectively suppressing electromagnetic interference caused by the radiation noise is in increasing demand.

In particular, as electronic devices are being spread nationally and internationally in recent years, the influence of erroneous operations and the like of the electronic devices and other devices caused by radiation noise of the devices exerted on the industrial society is large. Consequently, such electromagnetic interference is internationally strictly controlled by CISPR (Comite International Special des Perturbations Radioelectriques, or International Special Committee on Radio Interference) and the like.

The problem of such electromagnetic interference often occurs at the stage of evaluating a trial manufacture and exerts serious influence resulting retrogression of circuit designing, increase in development period, and the like. Development of a technique capable of easily suppressing noise without changing a circuit or the like is demanded.

To address the demand, a number of techniques for suppressing radiation noise have been developed. As one of the techniques, a ferrite layer is provided on the surface of an insulating substrate as described in Japanese Patent Laid-Open No. 2005-129766. In a radiation noise suppressing technique disclosed in Japanese Patent Laid-Open No. 2005-129766, a noise suppression member which is the ferrite layer is provided on the surface of a substrate.

In such a radiation noise suppressing technique, without specifying a wiring part as a noise source, the surface of the substrate is covered with the ferrite layer. Consequently, an extremely wide area covering electronic parts, lines, and the like is used, and radiation noise suppression is large-scale. Moreover, noise is suppressed in a frequency range of from hundreds of MHz to a few GHz in which the imaginary part µ" of magnetic permeability indicative of a loss component of the noise suppression member shows a high value.
There is consequently a problem that it is difficult to suppress noise in a frequency range of several tens of MHz. To solve such a problem, other problems are caused such as increase in cost and a change of the configuration of an electronic device due to addition of a shield and an electronic part.

### SUMMARY OF THE INVENTION

An object of the present invention is to solve the problems by enabling occurrence of radiation noise in a wiring part as a radiation noise generation source to be effectively suppressed.

The present invention provides a wiring board on which an electronic part is mounted, wherein a high-frequency current suppression member formed of a conductive soft magnetic film is provided in a state where at least a part of the member is in physical contact with a conductor part of a wiring line which can be a radiation noise source.

The wiring board includes various wiring boards such as a first board obtained by printing a wiring line by using a metal material such as copper on an insulating substrate, a second board obtained by providing, as a wiring line, a lead frame having a required circuit pattern on an insulating substrate, and a third board obtained by mounting an electronic part on a lead frame, using a part of the lead frame as a wiring line, and resin-molding the whole.

In the case of the first board, a soft magnetic film can be provided on the printed wiring line. In the case of the second and third boards, a soft magnetic film can be provided on the lead frame. It is also possible to use a jumper wire or the like as the wiring part, form a soft magnetic film on the jumper wire and, after that, mount the resultant on the first, second, or third board. The wiring shape in which the soft magnetic material is provided is not limited.

The invention is not limited to the method of providing the soft magnetic material in a film shape on the wiring line.

The kind of the soft magnetic material is not limited. The higher the value of the magnetic permeability is, the better. The magnetic permeability can be expressed by µ'-jµ". µ' denotes the real part of the magnetic permeability, and µ" denotes the imaginary part of the magnetic permeability and shows a loss component.

Examples of the soft magnetic material capable of providing the value of the magnetic permeability are permalloys such as iron nickel alloy, iron nickel boron alloy, iron nickel molybdenum alloy, iron nickel silicon alloy, iron nickel copper alloy, iron nickel chromium alloy, iron nickel copper molybdenum alloy, and iron nickel niobium alloy, iron cobalt alloy, iron cobalt nickel alloy, and cobalt zirconium niobium alloy.

In addition to the soft magnetic bodies, examples of preferable soft magnetic materials in the form of powders are iron aluminum silicon alloy (trademark "Sendust"), carbonyl iron, manganese zinc ferrite, and nickel zinc ferrite.

In the wiring board of the present invention, the high-frequency current suppressing member formed of a conductive soft magnetic film is provided in the conductor part of the wiring line generating radiation noise. Consequently, only the high-frequency current flowing in the skin of the wiring part can be extremely effectively attenuated by the skin effect. On the other hand, resistance of the suppressing member to direct current or low-frequency current is low, so that the direct current or low-frequency current flowing in the wiring is not disturbed.

From the above, conventionally, radiation noise is suppressed by providing a shield or a suppression member so as to cover the whole surface of the board including a source of noise radiated from a number of electronic parts, wiring lines, and the like mounted on the wiring board. In contrast, in the present invention, the high-frequency current suppression member formed of a conductive soft magnetic film is directly provided on the conductor part of a wiring line as a radiation noise source. Therefore, occurrence of radiation noise in the frequency range of from several tens of MHz to a few GHz can be extremely easily and effectively suppressed at low cost.

It is preferable to make the high-frequency current suppression member thicker than the skin of the wiring line from the viewpoint of suppressing occurrence of radiation noise by attenuation of the high-frequency current.

According to the present invention, the high-frequency current suppression member is provided in a thin film state directly on the outer peripheral surface of the conductor part of the wiring line as a radiation noise source or in a near field area which is within 5 cm from the conductor part.
Thus, occurrence of the radiation noise can be extremely effectively suppressed just before the radiation noise spreads.

Further, in the present invention, even if openings and gaps in various sizes exist in the casing of an electronic device, different from the conventional technique, radiation noise does not leak to the outside. The problems of the conventional technique can be solved all at once.

In particular, in the present invention, it is unnecessary to dispose a special radiation noise suppression part on the wiring board side unlike the conventional technique. Therefore, assembly of the wiring board is facilitated and the cost is reduced.

In the case of mounting the wiring board in an electronic device such as a personal computer, an electronic device in which radiation noise can be reduced by suppressing occurrence of radiation noise by the high-frequency current can be obtained as described above.

In the case of mounting the wiring board in a power supply unit such as a switching power supply, a power supply unit in which radiation noise can be reduced by suppressing occurrence of radiation noise by the high-frequency current can be obtained as described above. In the switching power supply as one of the power supply units, the high-frequency current suppression member can be provided in a current path in which the high-frequency current flows on the primary or secondary side of a high-frequency transformer.

In particular, in the present invention, the high-frequency current suppression member is provided in a near field, that is, close to a wiring line in which the surge impedance is small and the magnetic field is dominant. Consequently, the high-frequency current suppression member formed of a soft magnetic film, also as a magnetic shield covering the wiring line portion, can reduce radiation noise by effectively suppressing the high-frequency magnetic field.

In the case of mixing powders of the soft magnetic material of the high-frequency current suppression member into an organic binder and providing the resultant to the wiring part which can be a radiation noise source, the structure which can be easily handled is obtained. The structure can be properly and easily provided for the periphery of the wiring part generating radiation noise.

In the switching power supply, the power of radiation noise caused by higher harmonics accompanying switching operation of a switching transistor is high. Consequently, various countermeasures for suppressing radiation noise have been conventionally proposed but problems such as increase in weight, increase in cost, and leakage of radiation noise cannot be solved.

In the present invention, the high-frequency current suppression member formed of a soft magnetic material is provided in a magnetic field dominant area such as a near field of the wiring part as a radiation noise source. Thus, the radiation noise suppression configuration which is easy and low-cost can be provided, radiation noise can be suppressed efficiently, and practicability is extremely high.

### BRIEF DESCRIPTION OF THE DRAWINGS

FIG. 1 shows a plan view of a lead frame as a wiring board according to an embodiment of the present invention;
FIG. 2 shows a partial schematic view of electric circuits of a switching power supply;
FIG. 3 shows a diagram for explaining magnetic and electric fields generated by high-frequency loop current flowing in a lead frame part of FIG. 5;
FIG. 4 shows a diagram for explaining surge impedance;
FIG. 5 shows a cross section of a lead frame part (wiring part) in which loop current flows in a lead frame as the wiring board according to an embodiment of the present invention;
FIGS. 6A and 6B show diagrams of comparison between a radiation noise occurrence state in the case of magnetic-plating the lead frame with a soft magnetic film as a high-frequency current suppression member 18 and that in the case where the lead frame is not subjected to magnetic-plating, on the screen of a magnetic field strength measuring device;
FIG. 7 shows a graph of spectrum waveforms of a peak point in the case of magnetic-plating the lead frame part with a soft magnetic film as the high-frequency current suppression member 18 and that in the case where the lead frame part is not subjected to magnetic-plating;
FIG. 8 shows a diagram in which the lead frame part in FIG. 5 is provided with the high-frequency current suppression member 18 made of powders;
FIGS. 9A to 9C show diagrams in each of which the high-frequency current suppression member 18 in FIG. 5 is provided for a part of the lead frame part;
FIG. 10 shows a graph of frequency characteristics of the magnetic permeability;
FIGS. 11A to 11Q show the high-frequency current suppression members 18 in each of which a plurality of magnetic films are stacked;
FIG. 12 shows a diagram in which the high-frequency current suppression member 18 is provided for the lead frame part with a space or an insulator in between;
FIGS. 13A to 13D show diagrams in which the high-frequency current suppression members 18 are provided for terminals of electronic parts, a heat sink, and a metal casing;
FIG. 14 shows a perspective view of an annular metal body used for an analysis model;
FIGS. 15A to 15C show diagrams of results of measurement of radiation noise by the high-frequency current suppression member 18 by using the annular metal body of FIG. 14;
FIGS. 16A to 16C show diagrams of a current density distribution by a change in resistivity of the high-frequency current suppression member 18 by using the annular metal body of FIG. 14; and
FIGS. 17A and 17B show diagrams of results of measurement of radiation noise by the high-frequency current suppression member 18 made of a plurality of magnetic films by using the annular metal body of FIG. 14.

### DETAILED DESCRIPTION OF THE PREFERRED EMBODIMENTS

A wiring board according to an embodiment of the present invention and a switching power supply as an example of an electronic device (power supply unit) having the same will be described in detail hereinbelow with reference to the appended drawings.

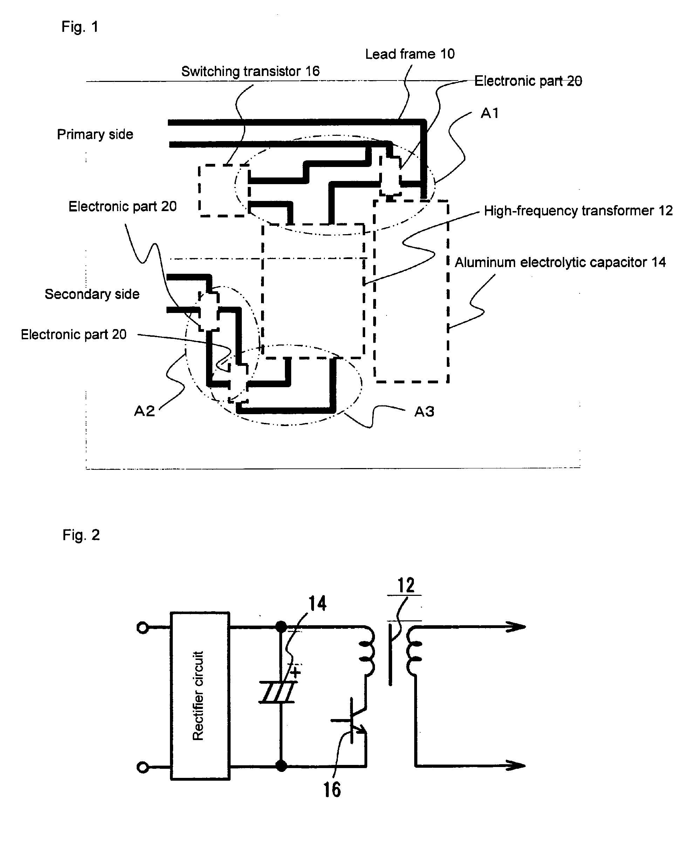

With reference to FIGS. 1 to 3, a wiring board according to an embodiment of the invention and a switching power supply having the same will be described. In an electronic device on which such a switching power supply is mounted, electromagnetic interference is tightly controlled in a frequency range of, for example, from 30 MHz to 1 GHz.

FIG. 1 is a schematic diagram showing the wiring board and electronic parts mounted on the wiring board. The wiring board in the diagram is constructed by a lead frame 10 corresponding to an electronic part mounting pattern of a switching power supply.

To the lead frame 10 shown by solid lines, mounting electronic parts constructing the power supply are fixedly connected. In FIG. 1, for simplification, as representative examples of the mounting electronic parts, a high-frequency transformer 12, an aluminum electrolytic capacitor 14 for smoothing as an electronic part on the primary side of the high-frequency transformer 12, a switching transistor 16 as a switching element, and an electronic part 20 mounted for grade-crossing the lead frame 10 are surrounded in rectangular shapes by broken lines.

The lead frame 10 has lead frame parts for mounting the electronic parts and lead frame parts for wiring lines connecting the electronic parts and the like. In FIG. 1, areas A1 to A3 surrounded by alternate long and short two dashes lines show radiation noise occurrence areas (as an example, areas in which loop current flows). In the areas, the radiation noise occurrence areas are shown on the primary side and the secondary side of the high-frequency transformer 12. The border between the primary side and the secondary side is indicated by an alternate long and short dash line.

FIG. 2 schematically shows only part of the electric circuits of the switching power supply corresponding to the electronic parts 12, 14, and 16. Since the circuit configuration of the switching power supply of FIG. 2 is well known, it will not be described.

The area A1 shown in FIG. 1 is an area of loop current LC flowing on the primary side of the high-frequency transformer 12.

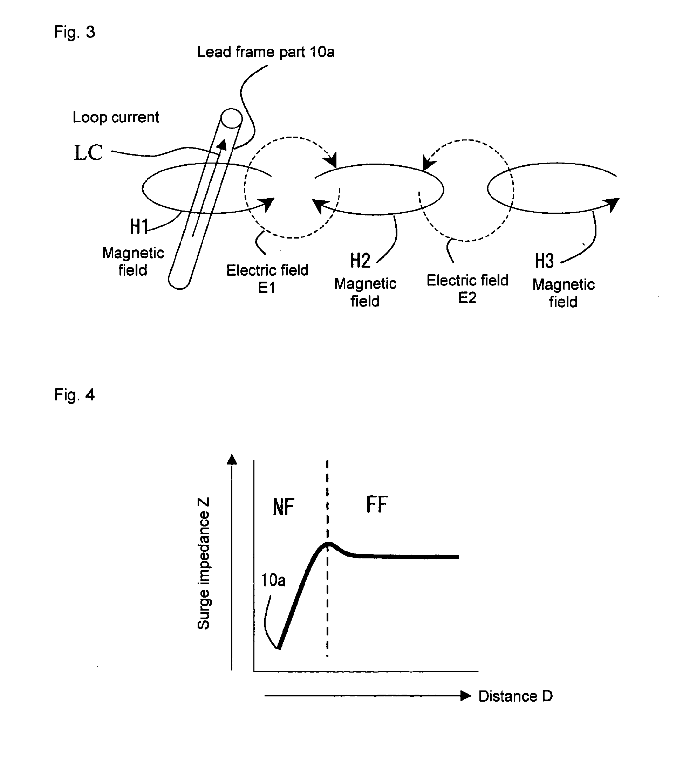

FIG. 3 shows a perspective view of part of a lead frame part 10a in which the loop current LC flows in the switching power source. In FIG. 3, by the loop current LC flowing in the lead frame part 10a, a magnetic field H1 is generated around the lead frame part 10a. By a change in the magnetic field H1, an electric field E1 is generated. By a change in the electric field E1, a magnetic field H2 is generated. By a change in the magnetic field H2, an electric field E2 is generated. In such a manner, the magnetic fields H1, H2, H3, ... and the electric fields E1, E2, ... are generated alternately.

In such a relation, when the loop current LC increases, the strength of the magnetic field increases. As the strength of the magnetic field increases, the strength of the electric field also increases. As the frequency of the loop current LC becomes higher, fluctuations in the magnetic field increase, and the strength of the electric field also increases.

As a result, when the loop current LC flows in the lead frame part 10a, radiation noise that the magnetic field and the electric field propagate alternately occurs. In this case, a magnetic field H1 is dominant near the lead frame part 10a (near field).

FIG. 4 shows a change in the surge impedance Z. In FIG. 4, the horizontal axis indicates distance D from the lead frame part 10a, and the vertical axis shows the surge impedance Z (= the electric field E at an arbitrary position/the magnetic field H at an arbitrary position).

As shown in FIG. 4, an area near the lead frame part 10a is a near field NF, and a far area is a far field FF. In the near field NF, the magnetic field H1 is dominant, and approximation to the magnetic field H1 can be performed.

The border between the near field NF and the far field FF is 1/2π of the wavelength λ of the electromagnetic wave, that is, about λ/6. The far field FF can be regarded as an electromagnetic wave obtained by totaling the electric field and the magnetic field.

Since the concept of the near field is λ/2π, in the case of radiation noise frequency of from 30 MHz to 1 GHz, the area of the near field is 1.7m to 5 cm. It is understood that, preferably, a high-frequency current suppression member is provided within 5 cm from the wiring part as a near field area in which the magnetic field component is stronger.

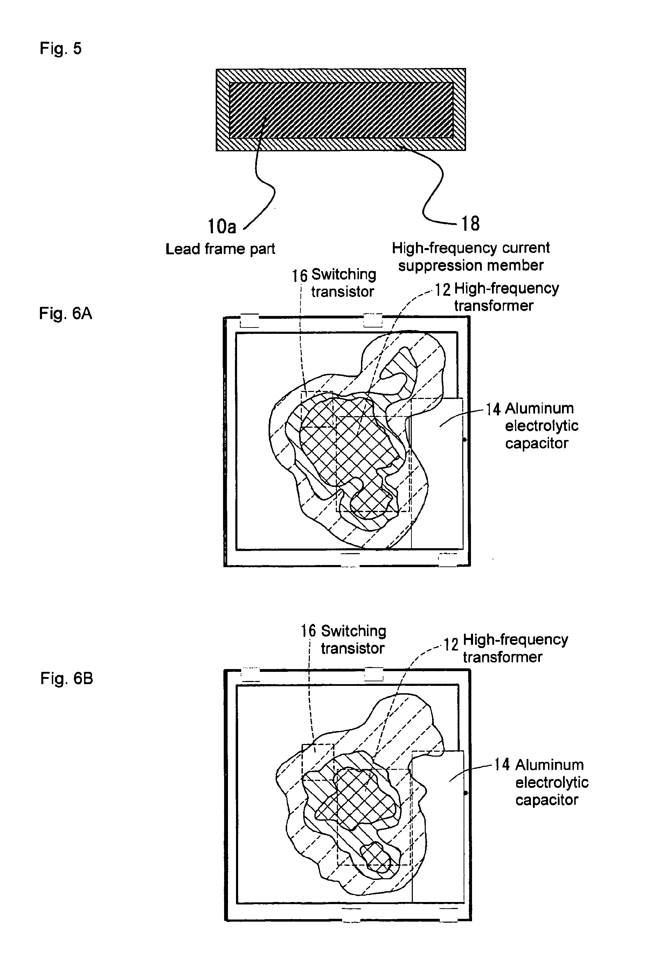

The wiring board and a switching power supply having the same will be described with reference to FIG. 5 showing the structure in which a high-frequency current suppression member formed of a conductive soft magnetic film is directly provided around a conductor part of the wiring line.

FIG. 5 shows a cross section of the lead frame part (wiring part) 10a in which the loop current LC flows. As shown in FIG. 5, a high-frequency current suppression member 18 is provided in a thin film form having uniform thickness so as to be in direct physical contact with the whole outer peripheral faces of the lead frame part 10a in order to suppress radiation noise from the lead frame part 10a most efficiently. The high-frequency current suppression member 18 is provided for the lead frame part 10a in which the loop current LC flows. The high-frequency current suppression member 18 is not provided for the lead frame part which does not generate radiation noise and for which the high-frequency current suppression member 18 is unnecessary, thereby enabling the material cost to be reduced.

As shown in FIG. 5, the high-frequency current suppression member 18 is formed in the lead frame part 10a in which the loop current LC flows on the primary side of the high-frequency transformer 12. The high-frequency current suppression member 18 is formed of a conductive soft-magnetic film having high magnetic permeability in a frequency range of from several tens of MHz to a few GHz.

Examples of the soft magnetic material of the high-frequency current suppression member 18 are permalloys such as iron nickel alloy, iron nickel boron alloy, iron nickel molybdenum alloy, iron nickel silicon alloy, iron nickel copper alloy, iron nickel chromium alloy, iron nickel copper molybdenum alloy, and iron nickel niobium alloy, iron cobalt alloy, iron cobalt nickel alloy, and cobalt zirconium niobium alloy.

The method of providing a soft magnetic material in a thin film shape is not limited. For example, the soft magnetic material can be formed into a thin film shape by electrolytic plating, electroless plating, sputtering, evaporation, rolling of a composite material, or the like.

FIGS. 6A and 6B show peak points of radiation noise in the case of observing the wiring board shown in FIG. 1 from above. FIG. 6A shows the case where the high-frequency current suppression member 18 is not provided on the lead frame part 10a, and FIG. 6B shows the case where the high-frequency current suppression member 18 is provided for the lead frame part 10a. In FIGS. 6A and 6B, to schematically show a color display screen of a magnetic field strength measuring device, an area where the magnetic field strength is high is indicated by thick-line cross hatching, an area where the magnetic field strength is intermediate is indicated by thick-line hatching, and an area where the magnetic field strength is low is shown by broken-line hatching.

As obvious from FIGS. 6A and 6B, in the case of providing the high-frequency current suppression member 18 for the lead frame part 10a, radiation noise is largely suppressed. Since it is not easily known from the color display screen, the positions of parts such as an aluminum electrolyte capacitor, a high-frequency transformer, and the like are indicated by broken lines so that they can be recognized.

The material of the lead frame part used for measurement in FIGS. 6A and 6B is copper, the soft magnetic material of the high-frequency current suppression member 18 is an iron nickel alloy having a thickness of 50 µm. The radiation noise was measured by the EMI measurement system (ESV-3000) of Noise Laboratory Co., Ltd. The measurement frequency was in a range from 30 MHz to 300 MHz.

The peak point in the area where the magnetic field strength is high in FIG. 6A is 90.4 dBµV and that in FIG. 6B is 87.7 dBµV. In the embodiment, the magnetic field strength decreases by about 3 dB. Obviously, the radiation noise suppressing effect is produced by the high-frequency current suppression member 18.

The reason why the radiation noise is reduced will be theoretically described.

High-frequency current flows in the skin of the lead frame part 10a by the skin effect. The skin thickness δ in this case is expressed by δ=√(ρ/µπf) where ρ denotes resistivity, µ denotes magnetic permeability, and f indicates frequency. As obvious from the equation of the skin thickness δ, since the high-frequency current suppression member 18 has high magnetic permeability, the high-frequency current can be effectively suppressed.

For example, in the case where the lead frame part 10a is made of copper and the high-frequency current suppression member 18 is an iron nickel alloy, the resistivity ρ of the lead frame part 10a is ρ = 1.7×10⁻⁸ Ωm and that of the high-frequency current suppression member 18 is ρ = 20×10⁻⁸ Ωm. The resistivity ρ of the high-frequency current suppression member 18 is higher.

Therefore, by reducing the skin thickness δ of the high-frequency current suppression member 18 as a soft magnetic material having high magnetic permeability µ and high resistivity ρ to increase the magnetic permeability µ and by effectively suppressing the high-frequency current by increasing the resistivity ρ, radiation noise can be suppressed.

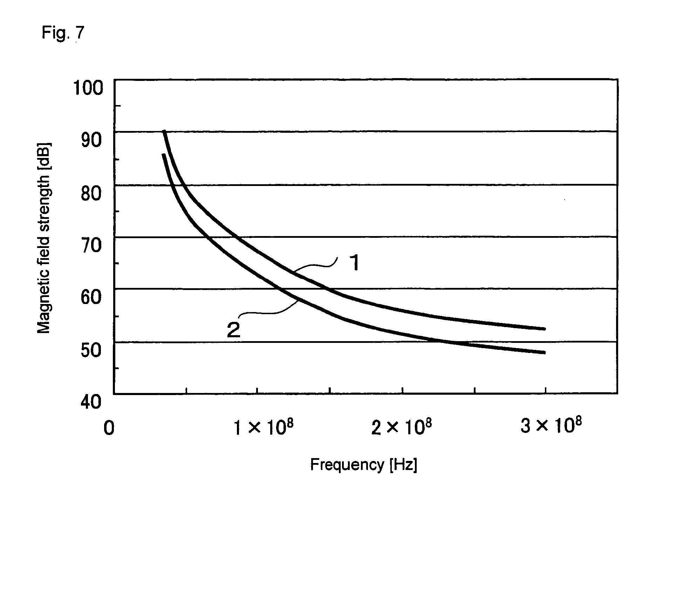

FIG. 7 shows the radiation noise reducing effect produced by the high-frequency current suppression member 18 in the whole frequency spectrum. FIG. 7 shows a spectrum waveform graph of peak points (the points of the maximum magnetic field strength), whose horizontal axis indicates frequency (Hz) and whose vertical axis indicates magnetic field strength (dBµV/m).

Data line 1 indicative of a measurement result shows the case where the high-frequency current suppression member 18 as a soft magnetic material is not magnetic plated on the lead frame part 10a. Data line 2 indicates the case where the high-frequency current suppression member 18 as a soft magnetic material is magnetic plated on the lead frame part 10a. The measurement frequency range is from 30 MHz to 300 MHz.

As described above, by providing, preferably directly, the high-frequency current suppression member 18 on the lead frame part (wiring part) 10a in which the high-frequency current flows, generation of the magnetic field is suppressed and leakage of radiation noise can be prevented.

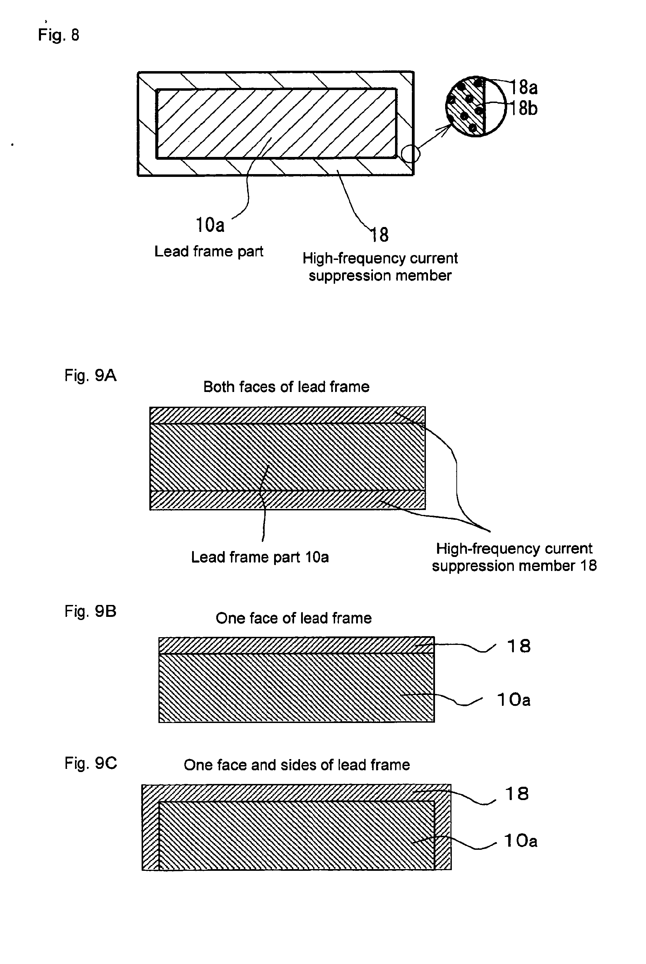

The high-frequency current suppression member 18 may have a structure of FIG. 8 in which soft magnetic materials 18a made of powders are directly provided or mixed in an organic binder 18b by being kneaded and dispersed or the like.

The shape of a powder may be a spheroidal shape or a fracture shape (flat shape, needle shape, or the like). When the powder shape is a flat shape or a needle shape, high magnetic permeability is expressed. On the other hand, when the powder shape is a spheroidal shape, there is no anisotropy in magnetic permeability, so that it is unnecessary to consider orientation of magnetic permeability.

Examples of preferable materials of the soft magnetic materials 18a in powders are iron aluminum silicon alloy (trademark "Sendust") having high-frequency magnetic permeability, carbonyl iron, manganese zinc ferrite, and nickel zinc ferrite. The soft magnetic powders 18a may be made of one material or a composite soft magnetic material made of a plurality of kinds of materials.

Examples of the organic binder 18b are heat-reversible resins such as ABS resin, polyester resin, polyvinyl chloride resin, polyvinyl butyral resin, polyurethane resin, cellulose resin, nitryl-butadiene rubber, and styrene-butadiene rubber or copolymers thereof.

Other examples of the organic binder 18b are thermosetting resins such as epoxy resin, phenol resin, amide resin, and imido resin.

A method of forming the high-frequency current suppression member 18 in powders is not limited but printing, dispersion, spray coating, a method of forming the high-frequency current suppression member 18 in a sheet state and adhering the sheet, a method of forming a sheet by die cutting and bonding the sheet, spraying powders, pressing, or the like may be used.

FIGS. 9A, 9B, and 9C show examples of the structure of the high-frequency current suppression member 18 made of the soft magnetic material. As shown in FIGS. 9A, 9B, and 9C, the high-frequency current suppression member 18 may be provided only in a part of the lead frame part 10a.

FIG. 9A shows a structure in which the high-frequency current suppression member 18 is provided for both faces of the lead frame part 10a. FIG. 9B shows a structure in which the high-frequency current suppression member 18 is provided for one face of the lead frame part 10a. FIG. 9C shows a structure in which the high-frequency current suppression member 18 is provided on one face and sides of the lead frame part 10a. The high-frequency current suppression member 18 may be provided on all or part of the periphery also in the case where the lead frame part 10a has a circular shape.

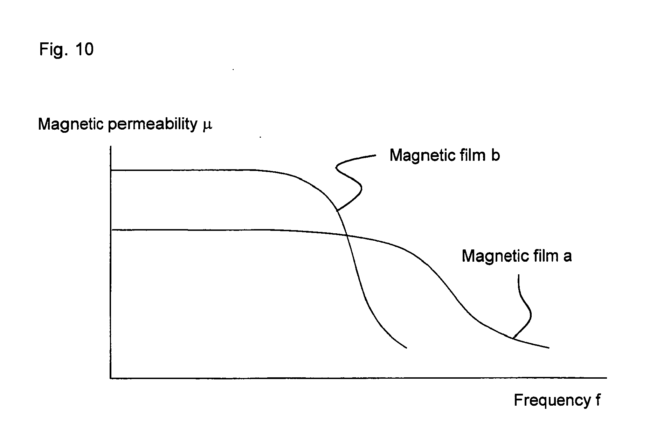

The high-frequency current suppression member 18 may be obtained by stacking a plurality of magnetic films "a" and "b" having different magnetic permeability as shown in FIG. 10. FIG. 10 shows frequency characteristics of the magnetic films "a" and "b" of different magnetic permeability. The magnetic film "a" has a high frequency characteristic up to a few GHz. The magnetic film "b" has a particularly high frequency characteristic up to several tens of MHz.

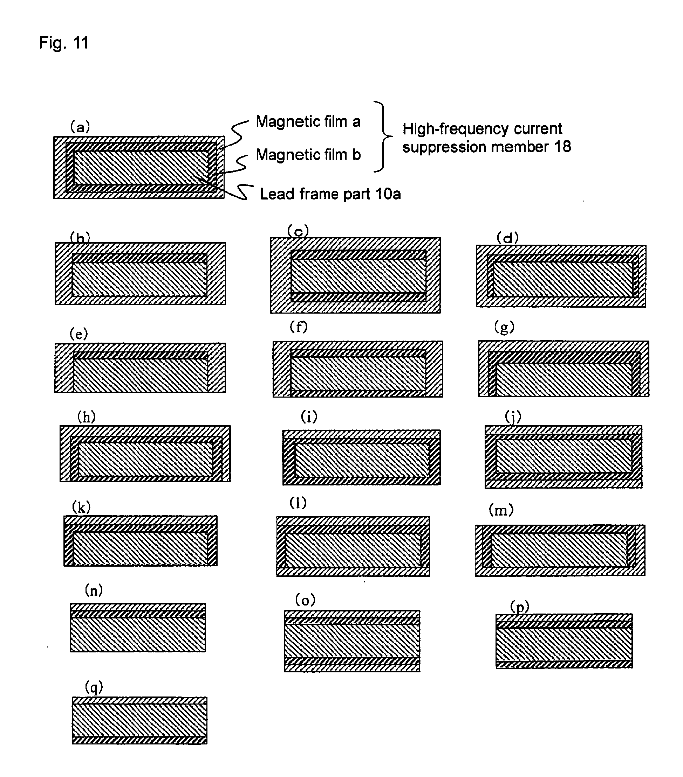

FIGS. 11A to 11Q show structures in each of which the high-frequency current suppression member 18 constructed by the magnetic films "a" and "b" is provided for the lead frame part 10a. Since the magnetic film "a" has a low high-frequency current suppressing effect up to a few GHz and the magnetic film "b" has a high high-frequency current suppressing effect up to several tens of MHz, by stacking the magnetic films "a" and "b", the radiation noise suppressing effect of a wide range of from several tens of MHz to a few GHz can be produced. The more the current of a few GHz flows, the more conspicuously the skin effect appears. It is consequently preferable to provide the magnetic film "a" of high magnetic permeability up to a few GHz on the outer side of the lead frame, which is the surface side. FIGS. 11A to 11Q show examples of the combination of the high-frequency current suppression member 18 in which the magnetic films "a" and "b" having different magnetic permeability are stacked. The invention is not limited to the number of films stacked and the method of combining the magnetic films.

The high-frequency current suppression member 18 may have a stack structure of a magnetic film and a resistive film having high resistivity. In the high-frequency current suppression member 18 made of only the magnetic films, the magnetic films are requested to have both of the characteristic of high magnetic permeability and the characteristic of high resistivity. By making the high-frequency current suppression member 18 of a magnetic film and a resistive film, radiation noise can be effectively suppressed. The configuration of the high-frequency current suppression member 18 made of the magnetic film and the resistive film is similar to the stack structures shown in FIGS. 11A to 11Q. Since the invention is not limited to the number of layers and combinations, a schematic diagram of the configuration is not shown. The material of the resistive film is not limited but may be aluminum (ρ=2.75×10⁻⁸ Ωm), zinc (ρ=5.9×10⁻⁸ Ωm), nickel (ρ=7.24×10⁻⁸ Ωm), tin (ρ=11.4×10⁻⁸ Ωm), chromium (ρ=17×10⁻⁸ Ωm), nichrome (ρ=109×10⁻⁸ Ωm), other high-resistive materials, an organic matter, an oxide, a composite material obtained by adding P, B, Mo, or the like. The resistive film may be formed by roughing such as mechanical polishing or etching using chemical reaction.

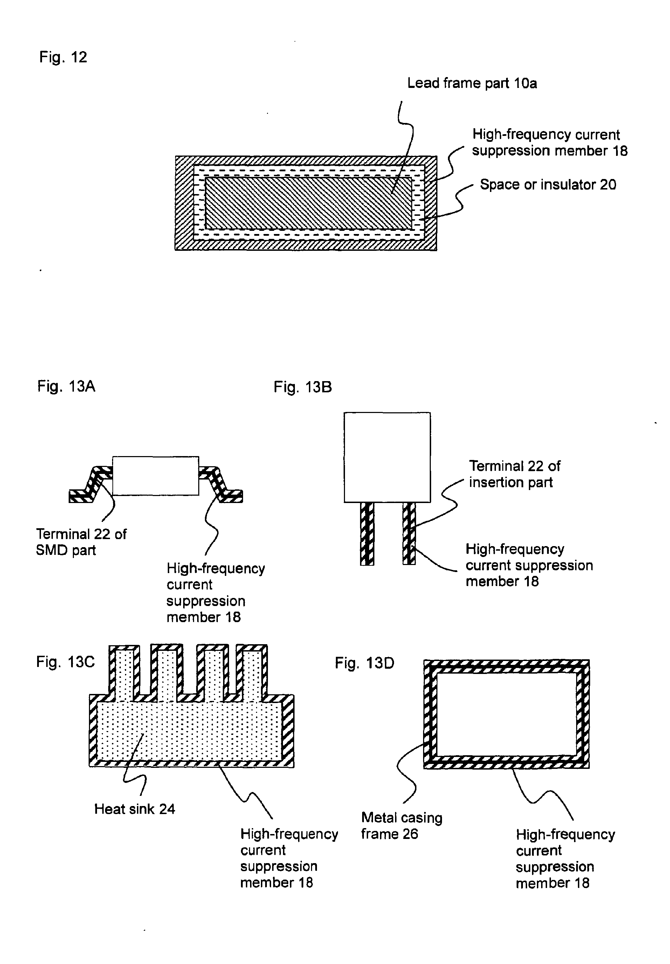

As shown in FIG. 12, the high-frequency current suppression member 18 may be provided for the lead frame 10a with a space or an insulator 20 in between. Since the skin thickness of the high-frequency current flowing in the lead frame 10a can be reduced according to the magnetic permeability of the magnetic film, the noise suppression effect can be obtained in a manner similar to the case of directly providing the magnetic film for the lead frame.

The high-frequency current suppression member 18 may be provided not only for a lead frame board on which a wiring part of an electronic circuit is formed by a plate-shaped metal but also for a printed board on which a metal material such as copper is printed on an insulating board.

The high-frequency current suppression member 18 may be provided for a terminal of an electronic part generating high-frequency noise such as a switching transistor, or a metal member near the terminal, for example, a terminal 22 of an electronic part, a heat sink 24, and a metal casing frame 26 as shown in FIGS. 13A to 13D. FIGS. 13A and 13B show the case where the high-frequency current suppression member 18 is provided for the terminal 22 of an electronic part. FIG. 13C shows the case where the high-frequency current suppression member 18 is provided for the heat sink 24. FIG. 13D shows the case where the high-frequency current suppression member 18 is provided for the metal casing frame 26. The terminal 22 of an electronic part is connected to the lead frame part 10a, and the heat sink 24 and the metal casing frame 26 are connected to the ground for stabilizing the potential.
Consequently, the high-frequency current causing radiation noise flows to the ground, thus by providing the high-frequency current suppression member 18 for each of the parts, the radiation noise can be similarly suppressed.

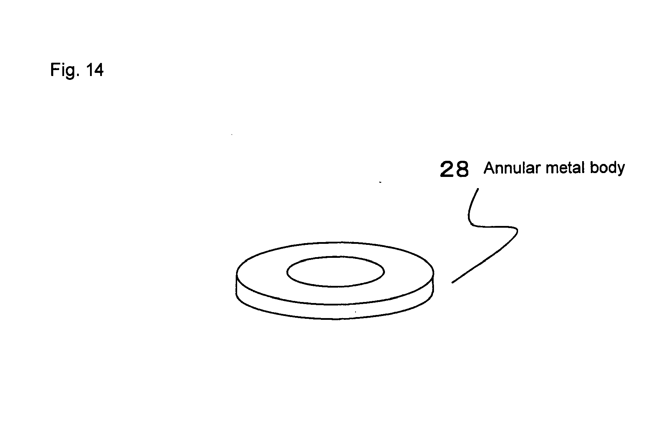

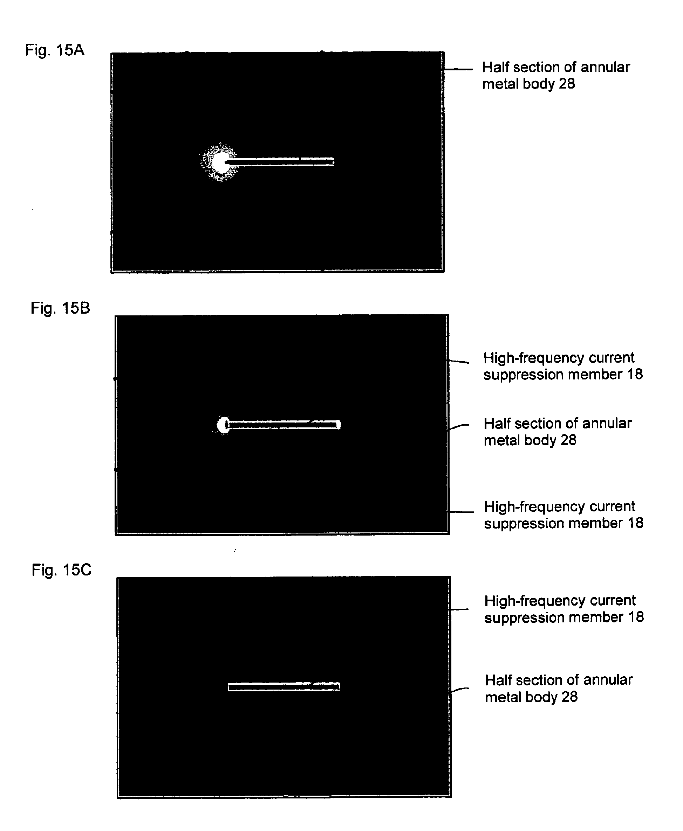

FIG. 14 and FIGS. 15A to 15C show analysis models related to suppression of the radiation noise. FIG. 14 is a perspective view of an annular metal body 28 in which the high-frequency loop current LC flows. FIG. 15A shows a result of analysis of radiation noise in the case where the high-frequency current suppression member 18 is not provided for the annular metal body 28. FIG. 15B shows a result of analysis of radiation noise in the case where the high-frequency current suppression member 18 is provided on the top and under faces of the annular metal body 28. FIG. 15C shows a result of analysis of radiation noise in the case where the high-frequency current suppression member 18 is provided on the entire peripheral surfaces of the annular metal body 28.

As obviously understood by comparing the analysis results of FIGS. 15A, 15B, and 15C, in the case where the high-frequency current suppression member 18 is provided on the entire peripheral surfaces of the annular metal body 28, the radiation noise can be suppressed maximally. The thickness of the high-frequency current suppression member 18 is 10 µm, and the analysis frequency is 30 MHz.

The magnetic film having higher magnetic permeability of the high-frequency current suppression member 18 is preferable. The range of magnetic permeability µ' and µ" in which the radiation noise can be suppressed are 5 to 10,000, and 0 to 500, respectively

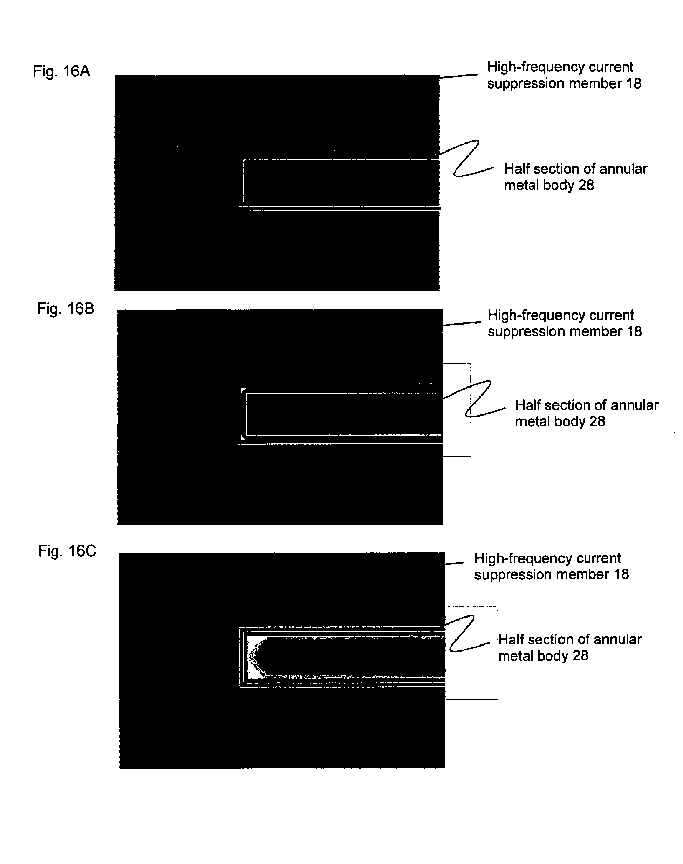

FIGS. 16A, 16B, and 16C show current density distributions in the case where the resistivity of the high-frequency current suppression member 18 is changed in the structure of FIG. 15C. FIGS. 16A, 16B, and 16C show current densities when the resistivity ρ = 2×10⁻⁸ Ωm, 100×10⁻⁸ Ωm, and 10,000×10⁻⁸ Ωm, respectively. As shown in FIGS. 16A, 16B, and 16C, the higher the resistivity ρ is, the less the current flows in the high-frequency current suppression member 18. It is therefore understood that the resistivity ρ of the high-frequency current suppression member 18 is desirably in a range from 2×10⁻⁸ Ωm to 10,000×10⁻⁸ Ωm.

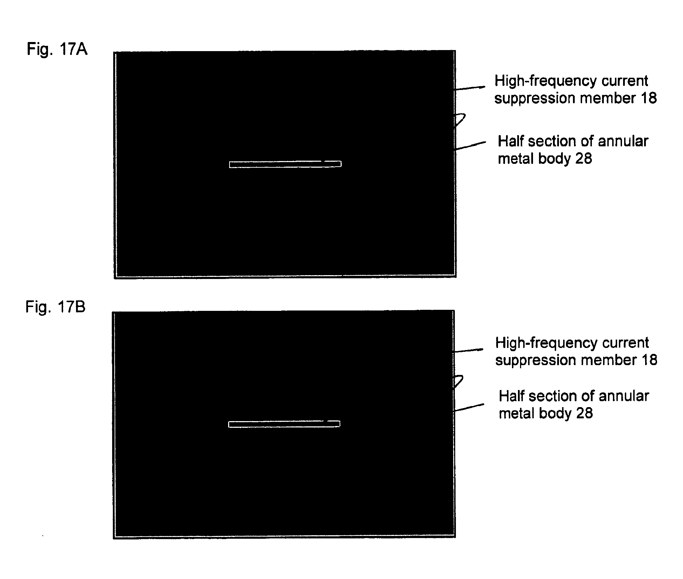

FIGS. 17A and 17B show analysis results of radiation noise suppression by the high-frequency current suppression member 18 constructed by two kinds of magnetic films. In FIG. 17A, 2 µm of the high-frequency current suppression member 18 made of a magnetic film "a" having magnetic permeability µ of 400 and resistivity ρ of 20×10⁻⁸ Ωm is provided. In FIG. 17B, the high-frequency current suppression member 18 made of a magnetic film "a" and a magnetic film "b" having magnetic permeability µ of 1000 and resistivity ρ of 20×10⁻⁸ Ωm is provided for the lead frame part 10a. The thickness of each of the magnetic films "a" and "b" in FIG. 17B is 1 µm. The analysis frequency is 30 MHz.

As understood by comparing the results of FIGS. 17A and 17B, by stacking a plurality of magnetic films, high-frequency noise is more effectively suppressed.

The high-frequency current suppression member 18 used for the analysis model is provided over the annular surface of the annular metal body 28. The size of the annular metal body 28 is 1.5 mmΦ. The radiation noise was analyzed by the electromagnetic field analysis tool (JMAG-Studio) manufactured by The Japan Research Institute, Limited.

The characteristics necessary for the high-frequency current suppression member 18 for suppressing radiation noise will be described.

The skin thickness δ is expressed by δ=√(ρ/µπf) where ρ denotes resistivity, µ denotes magnetic permeability, and f indicates frequency. Consequently, the higher the resistivity ρ is, the thicker the skin thickness δ becomes. When the skin thickness δ is considered as a sectional area S of the wiring part, a resistance value R of the wiring line is expressed as R = ρ×(L/S) = √(µπfρ)×L and tends to increase as the magnetic permeability µ and the resistivity ρ increases. L indicates length of the wiring line. That is, by increasing the magnetic permeability µ and the resistivity ρ of the wiring part, the resistance value R of the wiring line or the impedance Z can be increased.

Preferably, the magnetic permeability of the high-frequency current suppression member 18 formed of a soft magnetic film is higher. From the literature "Manufacture of high-resistivity Ni-Fe soft magnetic thin film by electrodeposition (Journal of The Surface Finishing Society of Japan, Vol. 49, No. 3, 1998)", it is understood that the magnetic permeability µ' is 1,000 at the maximum and the magnetic permeability µ" is about 500 in the literature in the band of tens MHz or higher by using an FeNi soft magnetic film. By adding diethylenetriamine (DET) or the like, attenuation of the magnetic permeability in the frequency range of 30 MHz or higher can be suppressed.

According to "Manufacture of soft magnetic NiFeB/NiPC/NiFeB stacked films by electroless plating (Digests of technical papers, the 23rd annual conference on magnetics in Japan, 1999)", the magnetic permeability µ' of FeNiB obtained by adding B to FeNi is similarly 1,000 at the maximum and the magnetic permeability µ" is about 500 in the band of tens MHz or higher.

The skin thickness δ is expressed by δ=√(ρ/µπf) where ρ denotes resistivity, µ denotes magnetic permeability, and f indicates frequency. The skin thickness δ of a magnetic film having the characteristics of the magnetic permeability µ of 1000 and resistivity ρ of 20×10⁻⁸ Ωm and that of a magnetic film having the characteristics of the magnetic permeability µ of 10 and resistivity ρ of 1000×10⁻⁸ Ωm will be described. When the frequency is 30 MHz, the skin thickness δ of the former magnetic film is 0.4 µm, and that of the latter magnetic film is 91.9 µm. When the frequency is 1 GHz, the skin thickness δ of the former magnetic film is 0.07 µm, and that of the latter magnetic film is 15.9 µm. It is therefore understood that the film thickness of the high-frequency current suppression member 18 preferably lies in the range of 0.1 µm to 100 µm in which the high-frequency current of 30 MHz to 1 GHz stays in the film.

It is understood that, also in the high-frequency current suppression member 18 made of a plurality of magnetic films or resistive films, preferably, each of the layers has a thickness according to the skin thickness.

As descried above, by providing the high-frequency current suppression member 18 directly for the lead frame part 10a in the part where the high-frequency current flows, generation of current is suppressed and leakage of radiation noise can be prevented.

In the case of mounting the wiring board on an electronic device such as a personal computer, an electronic device in which occurrence of radiation noise by the high-frequency current is suppressed and radiation noise is reduced can be obtained.

In the case of mounting the wiring board on a power supply unit such as a switching power supply, a power supply unit in which occurrence of radiation noise caused by the high-frequency current is suppressed and radiation noise is reduced can be obtained. In a switching power supply among the power supply devices, the high-frequency current suppression member 18 can be provided in a current path in which the high-frequency current flows on the primary side or secondary side of the high-frequency transformer.

The present invention is not limited to the foregoing embodiments but may be variously changed or modified within the scope of claims.

## Claims

1. A wiring board 10 on which an electronic part is mounted, **characterized in that** a high-frequency current suppression member 18 formed of a conductive soft magnetic film is provided in a state where at least a part of the member is in physical contact with a conductor part 10a of a wiring line which can be a radiation noise source.

2. The wiring board 10 according to claim 1, **characterized in that** magnetic permeability of the high-frequency current suppression member 18 µ' is 5 to 10,000, µ" is 0 to 500, and resistivity of the high-frequency current suppression member 18 ρ is 2×10⁻⁸ Ωm to 10,000×10⁻⁸ Ωm.

3. The wiring board 10 according to claim 1, **characterized in that** the high-frequency current suppression member 18 is formed of a plurality of conductive soft magnetic films layers 18.

4. The wiring board 10 according to claim 1, **characterized in that** the high-frequency current suppression member 18 is provided on an outer periphery of the conductor part of the wiring line which can be a radiation noise source.

5. The wiring board 10 according to claim 1, **characterized in that** the high-frequency current suppression member 18 is provided in a near field area which is within 5 cm from a wiring part which can be a radiation noise source.

6. The wiring board 10 according to claim 5, **characterized in that** the high-frequency current suppression member 18 is provided on the wiring part which can be a radiation noise source through a space or an insulator.

7. The wiring board 10 according to any one of claims 1 to 6, **characterized in that** the high-frequency current suppression member 18 is provided on a lead frame board on which a wiring part of an electronic circuit is formed by a metal plate.

8. The wiring board 10 according to any one of claims 1 to 6, **characterized in that** the high-frequency current suppression member 18 is provided on a printed board on which a wiring part of an electronic circuit is formed by a conductor printed on an insulating resin.

9. The wiring board 10 according to any one of claims 1 to 6, **characterized in that** the high-frequency current suppression member 18 is formed of a magnetic film and a resistive film whose resistivity lies in a predetermined range.

10. The wiring board 10 according to claim 9, **characterized in that** the resistive film is a resistive film whose resistivity ρ lies in a range of 2×10⁻⁸ Ωm to 10,000×10⁻⁸ Ωm.

11. An electronic device **characterized by** comprising the wiring board 10 according to any one of claims 1 to 6.

12. A power supply unit **characterized by** comprising the wiring board 10 according to any one of claims 1 to 6.

13. The electronic device according to claim 11, **characterized in that** the high-frequency current suppression member 18 formed of a conductive soft magnetic film 18a is provided on a metal body on which high-frequency noise can overlay.

14. The power supply unit according to claim 12, **characterized in that** the high-frequency current suppression member 18 formed of a conductive soft magnetic film 18a is provided on a metal body on which high-frequency noise can overlay.
